# EUROPÄISCHE PATENTANMELDUNG

(11) **EP 0 521 250 A2**
(43) Veröffentlichungstag der Anmeldung: **07.01.1993**
(21) Anmeldenummer: 92106329.3
(22) Anmeldetag: 13.04.1992
(51) Int. Cl.: G01R 15/02

(54) **Messwandler zum Messen eines Stromes mit einem Magnetfeldsensor**

(30) Priorität: 03.07.1991 CH 1970/91
(71) Anmelder: Landis & Gyr Business Support AG, CH-6301 Zug (CH)
(72) Erfinder: Seitz, Thomas, CH-6300 Zug (CH); Popovic, Radivoje, CH-6300 Zug (CH)
(74) Vertreter: Müller, Hans-Jürgen, Dipl.-Ing.

(57) **Zusammenfassung**

Ein Magnetkreis aus einem C-förmigen Magnetkern (1) mit einem Luftspalt (2), in dem ein Magnetfeldsensor (5) angeordnet ist, wird durch einen elektrischen Leiter (8) mit dem zu messenden Strom erregt. Ein Ausgangssignal des Magnetfeldsensors (5) ist dem zu messenden Strom proportional. Die Magnetisierungskennlinie des Magnetkerns (1) wirkt sich ohne besondere Massnahme als Fehler bei der Wandlung des zu messenden Stroms in eine magnetische Flussdichte im Luftspalt (2) aus. Das Besondere am Messwandler ist ein grosser Unterschied zwischen einer äusseren begrenzenden Figur (6) und einer inneren begrenzenden Figur (7) des Magnetkerns (1). Misst der Umfang der äusseren Figur (6) mindestens das Dreifache des Umfangs der inneren Figur (7), entsteht ein Glättungseffekt, der die nichtlineare Magnetisierungskurve kompensiert.

## Beschreibung

Die Erfindung bezieht sich auf einen Messwandler zum Messen eines Stromes mit einem Magnetfeldsensor der im Oberbegriff des Anspruchs 1 genannten Art.

Solche Messwandler eignen sich zum Messen von Gleich- oder von Wechselströmen. Sie können beispielsweise als Eingangswandler in einem statischen Elektrizitätszähler dienen.

Es ist ein Messwandler der im Oberbegriff des Anspruchs 1 genannten Art bekannt (UK Patent Application GB 2 228 337 A), der zum Messen von Gleichstrom eingesetzt werden kann.

Solche Messwandler bestehen im wesentlichen aus einem ringförmigen Magnetkern aus ferromagnetischem Material mit einem Luftspalt. Im Luftspalt ist ein Magnetfeldsensor, in diesem Fall ein Hallsensor, angeordnet. Der Magnetkern und der Luftspalt mit dem Magnetfeldsensor bilden zusammen einen magnetischen Kreis, der durch einen elektrischen Leiter mit dem zu messenden Strom erregbar ist.

Der Magnetkern aus ferromagnetischem Material dient zur Erhöhung der magnetischen Feldstärke im Luftspalt.

Sollen mit dem Messwandler kleine Ströme von z. B. einem Ampere erfasst werden, muss der magnetische Kreis einen möglichst kleinen magnetischen Widerstand aufweisen. Dies kann erreicht werden, wenn der wirksame Luftspalt im magnetischen Kreis etwa 0.5 mm - 1 mm misst.

Bei einem so kleinen Luftspalt ist der Einfluss des ferromagnetischen Materials des Magnetkerns an der Übertragung der magnetischen Erregung auf die magnetische Flussdichte im Luftspalt von Bedeutung, was aus der Anwendung des Amper'schen Gesetzes i = φ Hₛ ds folgt. Dabei bedeutet i den zu messenden Strom, Hₛ eine Feldstärkekomponente in Wegrichtung und s einen geschlossenen Weg um den Strom i. Der Weg s besteht beim Messwandler aus einem Weganteil l_{Fe} durch ferromagnetisches Material mit der Feldstärke H_{Fe} und einem Weganteil l_{Lu} durch den Luftspalt mit der Feldstärke H_{Lu}. Für den zu messenden Strom i gilt dann: i = H_{Fe}l_{FE} + H_{Lu}l_{LU}.

Der magnetische Widerstand des Magnetkerns ist vom gewählten Material und von der Länge des Weges einer Feldlinie abhängig.

Durch die Magnetisierungskennlinie des ferromagnetischen Materials ergibt sich ohne besondere Massnahme ein nichtlinearer Zusammenhang zwischen dem zu messenden Strom und der vom Magnetfeldsensor erfassten magnetischen Flussdichte im Luftspalt.

Der Erfindung liegt die Aufgabe zugrunde, einen Messwandler zum Messen eines Stromes mit einem Magnetfeldsensor so zu verbessern, dass eine genügend hohe und lineare Übertragung des zu messenden Stromes auf die magnetische Flussdichte im Luftspalt erreicht wird.

Die Erfindung besteht in den im Anspruch 1 angegebenen Merkmalen. Vorteilhafte Ausgestaltungen ergeben sich aus den abhängigen Ansprüchen.

Nachfolgend werden Ausführungsbeispiele der Erfindung anhand der Zeichnung näher erläutert.

Es zeigen:
- Fig. 1: eine Prinzipdarstellung eines Messwandlers,
- Fig. 2: eine prinzipielle Magnetisierungskennlinie von ferromagnetischem Material,
- Fig. 3: ein Ausführungsdetail des Messwandlers nach der Fig. 1,
- Fig. 4: einen Messwandler mit überlappenden Polflächen und
- Fig. 5: ein Ausführungsdetail des Messwandlers nach der Fig. 4.

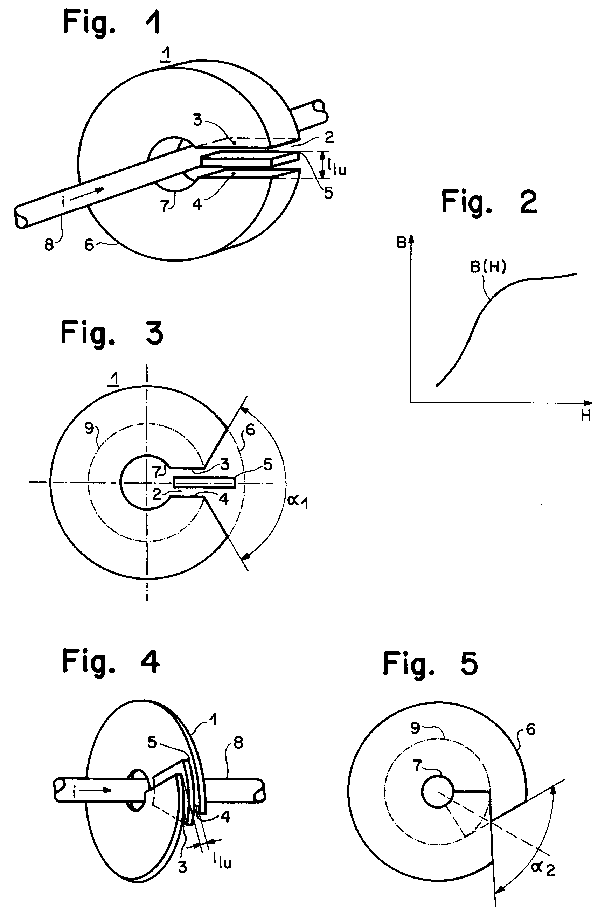

In der Fig. 1 bedeutet 1 einen als Ring ausgebildeten Magnetkern mit einem radial angeordneten Luftspalt 2 mit konstanter Länge l_{Lu} zwischen einer ersten Polfläche 3 und einer zweiten Polfläche 4. Im Luftspalt 2 zwischen den Polflächen 3 und 4 ist ein Magnetfeldsensor 5 angeordnet. Der Magnetkern 1 weist in der axialen Projektion auf eine Ebene senkrecht zur Zentrumsachse im wesentlichen eine C-Form auf, die von einer äusseren Figur 6 (Einfassungslinie) mit einem Umfang uₐ und einer inneren Figur 7 (Einfassungslinie) mit einem Umfang uᵢ begrenzt ist. Ein elektrischer Leiter 8 ist so durch eine zentrale Öffnung des Magnetkerns 1 geführt, dass der Magnetkern 1 durch den Leiter 8 erregbar ist.

In der Fig. 1 liegen die beiden Polflächen 3 und 4 im Abstand l_{Lu} parallel zum Luftspalt und senkrecht zur C-Form der axialen Projektion des Magnetkerns 1. Die äussere Figur 6 und die innere Figur 7 sind konzentrische Kreise.

Die elektrischen Anschlüsse des Magnetfeldsensors 5 zur Speisung sowie diejenigen zur Abnahme des Signals sind in der Zeichnung nicht dargestellt.

Der Magnetkern 1 und der Luftspalt 2 mit dem Magnetfeldsensor 5 zwischen den Polflächen 3 und 4 bilden einen Magnetkreis, der durch einen zu messenden Strom i im elektrischen Leiter 8 erregt ist. Im Magnetkreis wirkt ein inhomogenes magnetisches Feld mit einer Feldstärke H, die mit zunehmendem Abstand vom elektrischen Leiter 8 kleiner wird.

Vernachlässigt man den Luftspalt 2 und setzt für den Leiter 8 einen runden Querschnitt voraus, so gilt H = i / 2rπ, wobei r der Abstand der berechneten Feldstärke von der Mittelachse des Leiters 8 ist. Ein Feldbild im Magnetkern 1 besteht in diesem Fall aus konzentrischen kreisförmigen Feldlinien, die mit zunehmendem Abstand vom elektrischen Leiter 8 voneinander immer weiter entfernt liegen. Die kürzesten Feldlinien liegen also am dichtesten beieinander.

Die magnetische Flussdichte B im Magnetkern 1 ist von der Feldstärke H und vom Material des Magnetkerns 1 abhängig. In der Fig. 2 zeigt eine Magnetisierungskennlinie B(H) das prinzipielle Verhalten von ferromagnetischem Material im Magnetfeld H. Im unteren Bereich der Magnetisierungskennlinie B(H), d. h. bei niederer Feldstärke H, nimmt die Steilheit für grösser werdende Feldstärke H zu. B(H) ist also im unteren Bereich konkav gekrümmt; in diesem Bereich nimmt die magnetische Leitfähigkeit des Magnetkerns 1 überproportional zu. Im oberen Bereich der Magnetisierungskennlinie B(H) nimmt die Steilheit für grösser werdende Feldstärke H wieder ab. In diesem konvexen Teil der Magnetisierungskennlinie B(H) nimmt der magnetische Widerstand des Magnetkerns 1 mit zunehmender Feldstärke H überproportional zu, d. h. bei zunehmender Feldstärke H tritt eine für das betreffende Material des Magnetkerns 1 charakteristische Sättigung ein.

Das Besondere am beschriebenen Messwandler ist ein grosser Unterschied der beiden Umfänge uₐ und uᵢ. Da im Magnetkern die Feldstärke H radial gegen den elektrischen Leiter hin zunimmt, tritt eine Sättigungserscheinung im Magnetkern 1 zuerst lokal bei den kürzesten Feldlinien auf. Durch die Sättigungserscheinung nimmt der magnetische Widerstand des Magnetkerns 1 überproportional zu. Die Feldlinien bevorzugen in der Folge einen vom elektrischen Leiter 8 weiter entfernten Weg in einer Zone des Magnetkerns 1 mit geringerer Sättigung, obwohl da der Weg länger ist. Dadurch wird das magnetische Material des Magnetkerns 1 vom Leiter 8 her radial nach aussen entlastet, und es ergibt sich eine Homogenisierung des Feldes im Magnetkern. Durch die Homogenisierung wird die nichtlineare Magnetisierungskennlinie B(H) so ausgeglichen, dass die magnetische Flussdichte B im Magnetkreis praktisch linear vom Strom i abhängt. Bei einem Magnetkern 1 mit einem Luftspalt 2 der Länge l_{Lu} in der Grössenordnung von etwa 0,5 mm bis 1 mm tritt die für einen technisch nutzbaren Glättungseffekt der Magnetisierungskennlinie notwendige Homogenisierung ein, wenn der Umfang uₐ mindestens den dreifachen Wert des Umfangs uᵢ aufweist. Je nach zulässigem Fehler und verwendetem Material ist ein mindestens fünffacher Wert vorteilhaft.

Im Luftspalt 2 wird die magnetische Flussdichte B und damit der zu messende Strom i vom Magnetfeldsensor 5, der z. B. ein Hallsensor ist, erfasst.

Bei Ausnutzung des Glättungseffekts kann für die Fertigung des Magnetkerns 1 preisgünstiges Elektroblech (Dynamoblech) oder Ferrit verwendet werden.

Die beiden Figuren 6 und 7, welche die C-Form des Magnetkerns 1 in der Projektion begrenzen, müssen nicht Kreise sein. Um ein richtungsabhängiges Verhalten von kornorientiertem Material zu berücksichtigen, kann es von Vorteil sein, den Magnetkern 1 so auszubilden, dass mindestens eine der Figuren 6 oder 7 beispielsweise als Ellipse erscheint.

Ein vorteilhafter Verlauf der Feldlinien im magnetischen Kreis ergibt sich durch einen in der Fig. 3 dargestellten Übergang des Magnetkerns 1 gegen den Lufspalt 2 hin. Ausserhalb der Materialmitte 9 des Magnetkerns 1 laufen die Polflächen 3 und 4, unter einem nach aussen geöffneten Winkel α₁, dessen Scheitelachse parallel zur Achse des Magnetkerns 1 liegt, vom elektrischen Leiter 8 weg aus. Der Winkel α₁ beträgt vorteilhaft etwa 120 °.

Die in der Fig. 1 und in der Fig. 3 dargestellte C-Form des Magnetkerns 1 schirmt den Magnetfeldsensor 5 gegen magnetische Fremdfelder gut ab. Diese werden durch den Magnetkern 1 kurzgeschlossen und umgeleitet.

Die Fig. 4 zeigt einen Messwandler mit überlappenden Polflächen. Der Magnetkern 1 hat die Form einer Spiral-Lochscheibe (Wendelform) und weist in der axialen Projektion auf eine Ebene senkrecht zur Zentrumsachse im wesentlichen eine O-Form auf, die von einer äusseren Figur 6 mit einem Umfang uₐ und einer inneren Figur 7 mit einem Umfang uᵢ begrenzt ist. Ein mit der Polfläche 3 abgeschlossener erster Pol des Magnetkerns 1 überlappt einen mit der Polfläche 4 abgeschlossenen zweiten Pol so, dass die Polflächen 3 und 4 mindestens annähernd parallel zur O-förmigen Projektion liegen. Diese Ausführung ist vorteilhaft, wenn der Magnetkern 1 axial relativ dünn ist und z. B. aus einer Schicht aus magnetischem Material oder aus einer Schicht Blech aufgebaut ist. Die Polflächen 3 und 4 lassen sich genügend gross und dem gewählten Magnetfeldsensor 5 angepasst ausbilden.

Auch beim Messwandler mit überlappenden Polflächen müssen die Figuren 6 und 7, welche die O-Form in der Projektion des Magnetkerns 1 begrenzen, nicht Kreise sein. Um ein richtungsabhängiges Verhalten von kornorientiertem Material zu berücksichtigen, kann es von Vorteil sein, den Magnetkern 1 so auszubilden, dass mindestens eine der Figuren 6 oder 7 beispielsweise als Ellipse erscheint.

Ein vorteilhafter Feldlinienverlauf ergibt sich auch in der Variante nach der Fig. 4, wenn die beiden Pole ausserhalb der Materialmitte 9 des Magnetkerns 1 vom elektrischen Leiter 8 weg in einem nach aussen geöffneten Winkel, dessen Scheitelachse parallel zur Achse des Magnetkerns 1 liegt, auslaufen. Dies ist in der Fig. 5 dargestellt.

Der Messwandler nach der Fig. 4 lässt sich kostengünstig in Hybrid-Technik fertigen. Der Magnetfeldsensor 5 und der Magnetkern 1 werden auf einem Träger, z. B. einem Keramiksubstrat, montiert. Die elektrischen Verbindungen können dabei durch Siebdruck oder Bonden realisiert werden.

## Patentansprüche

1. Messwandler zum Messen eines Stromes mit einem Magnetfeldsensor (5), der in einem Luftspalt (2) zwischen einem ersten Pol mit einer Polfläche (3) und einem zweiten Pol mit einer Polfläche (4) eines im wesentlichen ringförmigen ferromagnetischen Magnetkerns (1) angeordnet ist, wobei der Magnetkern (1) durch einen den Strom führenden elektrischen Leiter (8) erregbar ist, dadurch gekennzeichnet, dass in der axialen Projektion des Magnetkerns (1) auf eine Projektionsebene senkrecht zur Projektionsachse der Umfang der äusseren (6) der beiden begrenzenden Figuren (6; 7) mehr als das Dreifache des Umfangs der inneren Figur (7) beträgt.

2. Messwandler nach Anspruch 1, dadurch gekennzeichnet, dass der Umfang der äusseren Figur (6) mehr als das Fünffache des Umfangs der inneren Figur (7) beträgt.

3. Messwandler nach Anspruch 1 oder 2, dadurch gekennzeichnet, dass der Magnetkern (1) so ausgebildet ist, dass die axiale Projektion des Magnetkerns (1) auf eine Projektionsebene senkrecht zur Projektionsachse eine C-Form ergibt und somit die Polflächen (3; 4) senkrecht zur Projektionsebene liegen.

4. Messwandler nach Anspruch 1 oder 2, dadurch gekennzeichnet, dass sich die beiden Pole des Magnetkerns (1) überlappen, so dass der Magnetkern (1) eine Wendelform hat, seine axiale Projektion auf eine Projektionsebene senkrecht zur Projektionsachse eine O-Form ergibt und die Polflächen (3; 4) mindestens annähernd parallel zur Projektonsebene liegen.

5. Messwandler nach einem der Ansprüche 1 bis 4, dadurch gekennzeichnet, dass der Magnetkern (1) aus Elektroblech oder Ferrit besteht.

6. Messwandler nach einem der Ansprüche 1 bis 5, dadurch gekennzeichnet, dass die beiden Pole des Magnetkerns (1) ausserhalb der Materialmitte (9) derart abgeschlossen sind, dass eine Abschlussfläche des ersten Poles mit einer Abschlussfläche des zweiten Poles einen Winkel einschliesst, der vom elektrischen Leiter (8) weg nach aussen geöffnet ist und dessen Scheitelachse parallel zur Achse des Magnetkerns (1) liegt.
